Europäisches Patentamt

European Patent Office

Office européen des brevets

(19)

(11) Publication number: **0 089 265**
A2

# (12) EUROPEAN PATENT APPLICATION

(21) Application number: 83400437.6

(22) Date of filing: 04.03.83

(51) Int. Cl.³: **H 01 L 21/265**
**H 01 L 21/82**

(30) Priority: 04.03.82 US 354688

(43) Date of publication of application:
21.09.83 Bulletin 83/38

(84) Designated Contracting States:
DE FR GB IT NL

(71) Applicant: FAIRCHILD CAMERA & INSTRUMENT
CORPORATION
464 Ellis Street
Mountain View California 94042(US)

(72) Inventor: Crossley, Peter Anthony
580 Arastradero Road Apt. No. 304
Palo Alto California 94304(US)

(72) Inventor: Tsai, Nan-Hsiung
43640 Tonica Road
Fremont California 94538(US)

(74) Representative: Chareyron, Lucien et al,
Schlumberger Limited Service Brevets 42, rue
Saint-Dominique
F-75340 Paris Cedex 07(FR)

(54) Process of ion implant masking in CMOS manufacture and resultant structure.

(57) A method of fabricating a CMOS device is provided for patterning the gates and protecting them during ion implantation.

A metal layer (20) is sandwiched between the gate material layer (18) and the photoresist layer (22) that is used as a pattern mask for the gate material during etching. The photoresist pattern (22) masks the metal as it is etched, and the metal pattern (20M) masks the gate material as it is etched to form a gate pattern. The metal mask is left over the gates to serve as an ion implant stop mask. Two photoresist patterns are successively formed to cover the devices of one conductivity type while the opposite type device source and drain regions are implanted.

Then, the metal mask may be easily stripped without causing damage.

FIG. 3

PROCESS OF ION IMPLANT MASKING

IN CMOS MANUFACTURE

AND RESULTANT STRUCTURE

By

P.A. CROSSLEY and N. TSAI

## FIELD OF THE INVENTION

This invention relates to the manufacture of complementary metal oxide semiconductor devices, and specifically to a process of masking against ion implantation.

## BACKGROUND

Complementary Metal Oxide Semiconductor (CMOS) devices are well known, and are fabricated by several conventional processes which generally start with a wafer of silicon and create regions of varing conductivity in and on the wafer. A CMOS device includes both positive (p-) and negative (n-) MOS transistors, both of which have a gate positioned above a channel separating a pair of regions called the source and drain. The source and drain are doped with one type of dopant to produce holes as majority carriers for p-mos transistors, or another type of dopant to produce electrons as majority carriers for n-mos transistors. CMOS devices, having both p-mos and n-mos devices, are more complex and difficult to manufacture than MOS devices. In both types of MOS transistor it is essential that the edges of the gate be vertically aligned as closely as possible with the neighboring edges of the source and drain regions. A gap can defeat transistor operation entirely, and an overlap degrades operation by creating electrical capacitive

0089265

coupling between the gate and the source or drain, an effect called Miller capacitance. CMOS transistors would work with gates of conductivity types complementary to each other and like their source and drain types, but connecting complementary gate junctions requires special steps such as use of chip area for metal shorting bars to ensure good electrical conductivity. Therefore it is desirable to use the same gate conductivity type for both devices, one or the other gate type being opposite its source and drain type. Source and drain doping can be done by diffusing or implanting dopants into the intended source and drain regions. By either method, if the doping is done first, then to form the gates a mask must be critically aligned between the source and the drain regions, but the alignment is never perfect. If the gates are formed first, they serve as a boundary for the ion doping process, hence "self-alignment." However, the gates must be protected against contamination by species used to dope the opposite conductivity type source and drain regions.

## PRIOR ART

One prior art method of manufacturing semiconductor devices with self-aligned gates is spinning on two layers of photoresist ("resist") to protect the gates during the doping steps. A first resist is applied over the gate material. The resist is patterned, and the gate material is etched to form the gates. The first resist is left in place, and a second resist is spun on over the first resist. It is desirable to increase the number of rework times possible in manufacturing, but double spinning interferes with reworking. Double spinning resist requires both positive and negative resists, which is undesirable. Another prior art method of protecting the gates during the doping steps is to grow an extra layer of oxide on them. However, chemicals used to strip this extra oxide also attack the oxide exposed in other surface regions, lowering the dielectric integrity of the oxide and increasing capacitance to the chip substrate.

## OBJECT OF THE INVENTION

It is therefore the object of this invention to provide a convenient CMOS manufacturing process for generating complementary source and drain regions with self-aligned single conductivity type gates.

## SUMMARY OF THE INVENTION

This invention provides a method of patterning the gates and protecting them during ion implantation. A metal layer, aluminum for example, is sandwiched between the gate material layer and the photoresist layer that would be used in the prior art as a pattern mask for the gate material during etching. In this invention, the photoresist pattern masks the metal as it is etched, and the metal pattern masks the gate material as it is etched to form a gate pattern. In conventional processes when a gate mask of photoresist is used, it is next removed and does not protect the gates during ion implantation. According to this invention, the metal mask is left over the gates to serve the second purpose of an ion implant stop mask. A new photoresist pattern is formed, noncritically aligned, to cover all of the devices of one conductivity type and form a first ion implant stop mask to protect their source and drain regions while the opposite type device source and drain regions are implanted. The first ion implant stop mask is stripped off, and a second

50.4147
0089265

ion implant stop mask is formed to cover the previously uncovered devices. The now uncovered source and drain regions are implanted. Then, the second ion implant stop mask is stripped off. The metal mask protects the gates through all these steps, and then, having a different chemistry than the other device components, the metal may be easily stripped without causing damage. This process results in a higher quality structure at this stage than previously obtainable, and ultimately, after completion of conventional steps remaining in CMOS manufacturing processes, a higher percentage of good circuits.

## BRIEF DESCRIPTION OF THE DRAWINGS

Fig. 1 is a cross-sectional elevational view of a substrate illustrating a device well and field isolation regions covered by a layer of gate material and a layer of metal;

Fig. 2 illustrates a photoresist pattern formed on the metal layer of the Fig. 1 substrate for use in gate definition;

Fig. 3 illustrates the metal layer of Fig. 2 removed according to the photoresist gate definition pattern;

Fig. 4 illustrates the metal pattern of Fig. 3 with the photoresist removed, and the gate material etched according to the metal and resist pattern;

Fig. 5 illustrates formation of devices of one conductivity type; and

Fig. 6 illustrates formation of devices of another conductivity type.

## DETAILED DESCRIPTION OF THE INVENTION

Referring to the figures illustrating a preferred method of practicing this invention, the process begins with a

0089265

lightly doped n-type silicon wafer substrate 12, typically of 2 to 4 ohm/cm resistivity and 20 mils thickness, cut in the 100 orientation. Preferably an initial oxide layer (not shown) is formed by thermal oxidation to a thickness of 3000 angstroms. Through conventional processes of spinning on photoresist, masking, etching, ion implantation, photoresist stripping, and well-drive oxidation, p-type wells 14 are formed in the substrate 12 where n-type devices will be fabricated. Channel stops (not shown) for the wells are also formed by conventional processes. A field oxide 16 about 5500 angstroms thick is grown, each field oxide 16 being adjacent a well 14. After transistor threshold control implants are performed, a gate oxide 11 about 250 angstroms thick and continuous with the field oxide 16 is grown in active device areas by thermal oxidation. This gate oxide 11 extends on one side of the field oxide 16 over the well 14 and on the other side over the substrate 12. A layer of N-type gate material 18 such as polysilicon and/or metal silicide is formed by chemical vapor deposition over the entire surface. This layer is typically a total of 4300 angstroms thick.

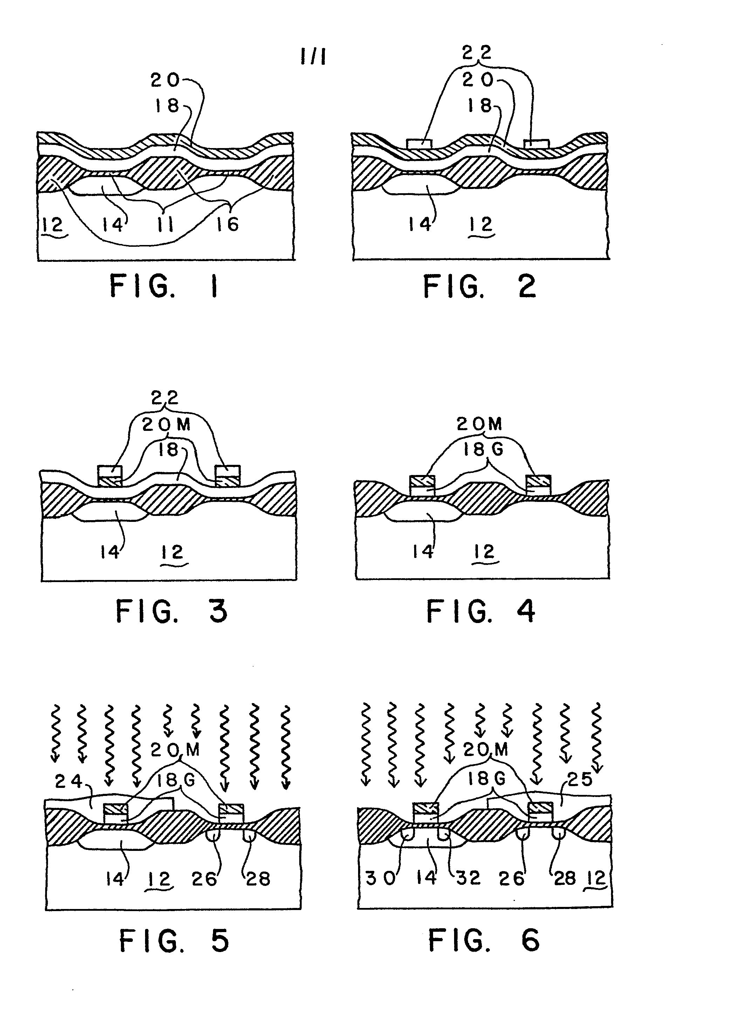

Over the gate material, a layer of metal 20 such as aluminum typically 3500 angstroms thick as shown in Fig. 1 is deposited by evaporation under vacuum. A layer of suitable conventional photoresist (not shown), such as AZ1470 by the Shipley Co., is then spun on over the aluminum. The photoresist is exposed using the gate definition mask and developed. The resist is removed from all areas other than the pattern for gates, leaving a mask of resist 22 as shown in Fig. 2. The aluminum is then removed, preferably using an anistropic dry etch method (e.g., Radio Frequency (RF) discharge in carbon tetrachloride at 200 milliTorr pressure) to minimize undercut into the gates, yielding a structure including a metal mask 20M as shown in Fig. 3. The invention at this stage has created a new structure, not taught by the prior art. Working with and building upon this new structure makes it possible to gain the advantages and improvements in self-aligned gates described above. Self-aligned same conductivity type gates can now be obtained without the problems encountered in using double spun resist or an extra layer of oxide.

The patterned layers of resist 22 and aluminum 20M are used to define the polysilicon gates 18G during treatment with another preferential etch (e.g., RF plasma discharge in chlorine gas at 300 to 500 milliTorr pressure). The gate pattern photoresist is stripped, but the aluminum overlying and covering the gates remains as shown in Fig. 4.

A new layer of photoresist 24, which may be the same kind as used previously, is applied to the substrate device surface, and developed to form a pattern covering all of the areas for one conductivity type device. This mask alignment over all of one type device is non-critical, as the edges of the developed photoresist need only fall somewhere along the field isolation regions separating the device types. The source 26 and the drain 28 regions of the p-devices, which are not covered in this example, are now implanted by well known ion implantation techniques, which may include bombardment with positive boron ions from a boron tri-fluoride beam at 150 KEV to achieve an impurity level of 5 x 10 exp 15 ions/square cm. Although the resist layer 24 is non-critically aligned, the resist cannot be exposed to a temperature typically exceeding 120 degrees C. or it will become difficult to strip, so the implantation is preferably done on a carousel type implanter.

The aluminum 20M is unaffected by temperatures compatible with the resist 24. Ion implantation necessarily forms source 26 and drain 28 regions right up to the metal-defined gates 18G. Furthermore, the aluminum or other metal 20M has ion stopping capability superior to the prior art materials, namely photoresist or an extra layer of oxide. Thus the gates are "self-aligned" with no overlap onto the source or drain regions, so that Miller capacitance is minimized.

The resist 24 (covering the n-mos devices) is then stripped. A new layer of resist 25 is spun on and developed in a non-critical pattern covering the just-implanted p-mos devices. The n-mos source 30 and drain 32 regions are formed by a comparable ion implantation technique, using for example a 100 KEV beam of positive arsenic or phosphorus ions to obtain a concentration in the range of 3 x 10 exp 15 ions/square cm (Fig. 6). The resist 25 which covers the p-mos devices is then stripped. The aluminum 20M is also stripped. A suitable stripping etch would be 16 parts by volume of deionized water, 2 parts of phosphoric acid, and 1 part each of acetic acid and nitric acid. Because aluminum, or other metal which may be used, has chemical properties completely different than the field or gate oxide, it may be easily stripped without doing damage to the other layers. This is an advantage not obtained in the prior art process of fabricating self-aligned gates using an extra oxide layer, which is removed at the expense of thinning, and lowering the dielectric integrity of, the field oxide.

It will be seen that during implant of the p-type source 26 and drain 28, the photoresist 24 holds the p-type aluminum 20M adjacent the source 26 and drain 28 blocks the p- type implant from the n-type gate 18G thereunder.

The CMOS integrated circuit is completed by well known processes for source and drain oxidation, contact formation, conductor interconnect deposition and definition, and alloying the conductors to contacted areas.

An alternative method of practicing this invention would use a refractory metal such as tungsten, molybdenum, or tantalum in place of the aluminum. In this case, the major process steps remain as above through the steps as shown in Fig. 5, and then the metal could either be stripped like the aluminum, or a high temperature process could be used to chemically react the metal with a portion of the underlying polycrystalline silicon, to form a refractory metal silicide, as explained in "Refractory Silicides for Integrated Circuits" by S. P. Murarka, The Journal of Vacuum Science Technology 17, pg. 775 (July-Aug. 1980).

It will readily be recognized that all conductivity types as above described can be reversed. Furthermore, it will be readily understood that the sequence of providing photoresist 24 and photoresist 25, and the implantation of the p- type and n- type sources and drains, can be reversed.

Although the foregoing description uses parameters for a specific application, it should be understood that the invention is equally applicable to any semiconductor manufacturing process wherein it is desired to dope a given region and not affect adjacent polysilicon.

<u>CLAIMS</u>

1. The method of fabricating a semiconductor device which comprises the step of :

providing a substrate (12) of a first conductivity type, having a well (14) of a second conductivity type therein, a field oxide isolation region (16) in the substrate, the field oxide isolation region being adjacent the well, and a gate oxide layer (11) extending on one side of the field oxide isolation region over the well (14) in the substrate and on the other side of the field oxide isolation region over the substrate (12), characterized by comprising the steps of :

providing a layer (18) of gate material of said one conductivity type over the oxide ;

providing a layer (20) of metal over the layer of gate material ;

removing portions of said layer of metal and said layer of gate material according to a desired gate definition pattern, leaving metal portions (20M) overlying gate portions (18G) in turn on the gate oxide ;

providing a first ion implant stop mask (24) over the area intended for a first conductivity type device ;

implanting source and drain regions (26,28) for a second conductivity type device ;

removing said first ion implant stop mask (24) ;

providing a second ion implant stop mask (25) over the area not formerly covered by said first ion implant stop mask ;

implanting source and drain regions (30,32) in said area intended for a first conductivity type device ; and removing said second ion implant stop mask (25).

2. The method of Claim 1 characterizd by further comprising the step of removing said metal which has remained according to said gate definition pattern.

3. The method of Claim 1 characterized by further comprising the step of alloying said metal remaining according to said gate definition pattern, to form a refractory metal silicide.

4. The method of anyone of claims 1 to 3 characterized in that the step of providing a layer of metal comprises the step of providing a layer of aluminium.

5. The method of anyone of claims 1 to 3 characterized in that the step of providing a layer of metal comprises the step of providing a layer of tantalum.

6. The method of anyone of claims 1 to 3 characterized in that the step of providing a layer of metal comprises the step of providing a layer of molybdenum.

7. The method of anyone of claims 1 to 3 characterized in that the step of providing a layer of metal comprises the step of providing a layer of tungsten.

8. A semiconductor structure comprising :

a substrate (12) of semiconductor material of a first conductivity type ;

a well (14) of a second conductivity type on the surface of the substrate, and

a layer (11) of gate oxide on said one surface of said substrate, characterized by comprising :

a layer (18) of gate material on said layer (11) of gate oxide, and

a layer (20) of metal on said layer of gate material, said layer of metal being patterned to provide a mask for patterning said layer of gate material.

1/1

FIG. 1

FIG. 2

FIG. 3

FIG. 4

FIG. 5

FIG. 6